(19) Europäisches Patentamt
European Patent Office
Office européen des brevets

(11) **EP 2 648 335 B1**

## (12) FASCICULE DE BREVET EUROPEEN

(45) Date de publication et mention
de la délivrance du brevet:
**06.05.2020   Bulletin 2020/19**

(21) Numéro de dépôt: **13162459.5**

(22) Date de dépôt: **05.04.2013**

(51) Int Cl.:
*H03G 11/00* (2006.01)          *H01H 59/00* (2006.01)
*B81B 7/04* (2006.01)

(54) **Limiteur de puissance hyperfréquence à commutateurs MEMS radiofréquences capacitifs**

Hyperfrequenz-Leistungsbegrenzer mit kapazitiven Funkfrequenz-MEMS-Schaltern

Hyperfrequency power limiter with capacitive radiofrequency MEMS switches

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.04.2012   FR 1201015**

(43) Date de publication de la demande:
**09.10.2013   Bulletin 2013/41**

(73) Titulaire: **Thales**
**92400 Courbevoie (FR)**

(72) Inventeurs:
  • **Gauvin, Jonathan**
    **19100 Brive (FR)**
  • **Vendier, Olivier**
    **31320 Aureville (FR)**
  • **Cazaux, Jean-Louis**
    **31100 Toulouse (FR)**
  • **Blondy, Pierre**
    **87000 Limoges (FR)**
  • **Villemazet, Jean-François**
    **31550 Cintegabelle (FR)**

(74) Mandataire: **Esselin, Sophie et al**
**Marks & Clerk France**
**Conseils en Propriété Industrielle**
**Immeuble Visium**
**22 avenue Aristide Briand**
**94117 Arcueil Cedex (FR)**

(56) Documents cités:
**FR-A1- 2 930 373     US-A1- 2011 057 740**

• VAN CAEKENBERGHE K: "RF MEMS on the radar", IEEE MICROWAVE MAGAZINE, IEEESERVICE CENTER, PISCATAWAY, NJ, US, vol. 10, no. 6, 1 octobre 2009 (2009-10-01), pages 99-116, XP011276501, ISSN: 1527-3342, DOI: 10.1109/MMM.2009.933596
• JONSSON R ET AL: "An experimental study of standard packaged/unpackaged GaAs MMIC based RF-MEMS limiter test circuits", SEMICONDUCTOR CONFERENCE (CAS), 2011 INTERNATIONAL, IEEE, 17 octobre 2011 (2011-10-17), pages 203-206, XP032069184, DOI: 10.1109/SMICND.2011.6095759 ISBN: 978-1-61284-173-1
• ROTTENBERG X ET AL: "MEMS capacitive series switches: optimal test vehicles for the RF self-biasing phenomenon", MICRO ELECTRO MECHANICAL SYSTEMS, 2005. MEMS 2005. 18TH IEEE INTERNATI ONAL CONFERENCE ON MIAMI BEACH, FL, USA JAN. 30 - FEB. 3, 2005, PISCATAWAY, NJ, USA,IEEE, 30 janvier 2005 (2005-01-30), pages 147-150, XP010811680, DOI: 10.1109/MEMSYS.2005.1453888 ISBN: 978-0-7803-8732-4

EP 2 648 335 B1

**Description**

DOMAINE TECHNIQUE

Le domaine de l'invention est celui des limiteurs de puissance de signal hyperfréquence utilisés dans les architectures d'équipements hyperfréquence, pour limiter ou écrêter un signal hyperfréquence incident qui devient soudainement trop fort, afin de protéger les éléments sensibles de la chaîne de traitement de signal, en aval.

Les augmentations soudaines, non prévisibles, de puissance d'un signal hyperfréquence peuvent être le fait de sources externes telles que des brouilleurs, ou le fait de sources internes à l'architecture, par exemple provenant d'une chaîne d'émission radiofréquence.

Les téléphones portables ou les radars sont deux exemples d'équipements hyperfréquence contenant de tels limiteurs de puissance. Le limiteur est généralement dans la chaîne de traitement de signal de la voie de réception, généralement immédiatement entre l'antenne réceptrice et l'étage amplificateur faible bruit (LNA : *Low Noise Amplifier*) de cette chaîne.

Un limiteur de puissance d'un signal hyperfréquence doit satisfaire à différents impératifs. Il doit tenir des puissances signal élevées ; il doit avoir un temps de réponse le plus faible possible, typiquement de l'ordre de la nanoseconde, afin de protéger efficacement les étages sensibles en aval ; il doit avoir une consommation d'énergie la plus faible possible ; pour des puissances incidentes faibles, il doit être passant avec une réponse linéaire et des pertes d'insertion faibles, pour ne pas perturber les éléments de la chaîne de traitement en aval ; inversement, lorsque le signal incident dépasse un seuil de puissance déterminé, il doit être bloquant, présenter des pertes d'insertion très élevées, et ne pas se relâcher trop rapidement (dynamique de réponse), pour absorber ou limiter cette puissance et ainsi protéger efficacement les éléments en aval. La compacité, l'intégrabilité et le coût de revient du limiteur font aussi l'objet d'une grande attention.

ETAT DE L'ART

Les limiteurs de l'art antérieur utilisent des diodes semiconductrices de détection, typiquement des diodes PIN ou Schottky, intégrées sous forme de composants discrets, en boîtier. Outre le manque de compacité et le coût élevé de ces limiteurs, leur consommation en courant est non négligeable, de l'ordre de quelques dizaines de milliampères au moins, induisant des pertes de puissance signal de l'ordre de 1dB. Leur réponse est linéaire pour les forts niveaux de puissance, ce qui n'est pas la réponse la plus efficace.

Il est par ailleurs connu, par exemple de la demande de brevet français publiée sous le No FR 2 930 373, ou de la demande EP 2 110 881 correspondante, d'utiliser un commutateur formé par un microsystème électromécanique radiofréquence, c'est-à-dire un commutateur MEMS radiofréquence (RF), comme limiteur de puissance d'un signal hyperfréquence. Un tel commutateur comprend une électrode mobile au-dessus d'une ligne signal qui transporte le signal hyperfréquence, électrode mobile qui va s'abaisser vers l'électrode signal en cas de forte puissance. Ce commutateur est équivalent à une capacité (en réalité un circuit R, L, C, mais R et L sont négligeables) qui prend deux valeurs : l'une correspondant au mode passant dans lequel l'électrode mobile est dans un état haut, correspondant à son état initial, au repos, qui se caractérise par un espacement initial $g_0$ entre l'électrode mobile et la ligne signal ; et l'autre correspondant au mode bloquant du commutateur dans lequel l'électrode mobile est dans un état bas, qui se caractérise par un espacement minimal $g_{down} < g_0$ entre l'électrode mobile et la ligne signal.

Le mode d'actionnement de ce commutateur est électrostatique : c'est la ligne de transmission du signal hyperfréquence qui sert d'électrode d'actionnement électrostatique du commutateur. Cet actionnement est obtenu lorsqu'aux bornes du commutateur, la tension efficace dite aussi tension RMS, due à la puissance du signal hyperfréquence, atteint la tension d'actionnement DC du commutateur MEMS RF.

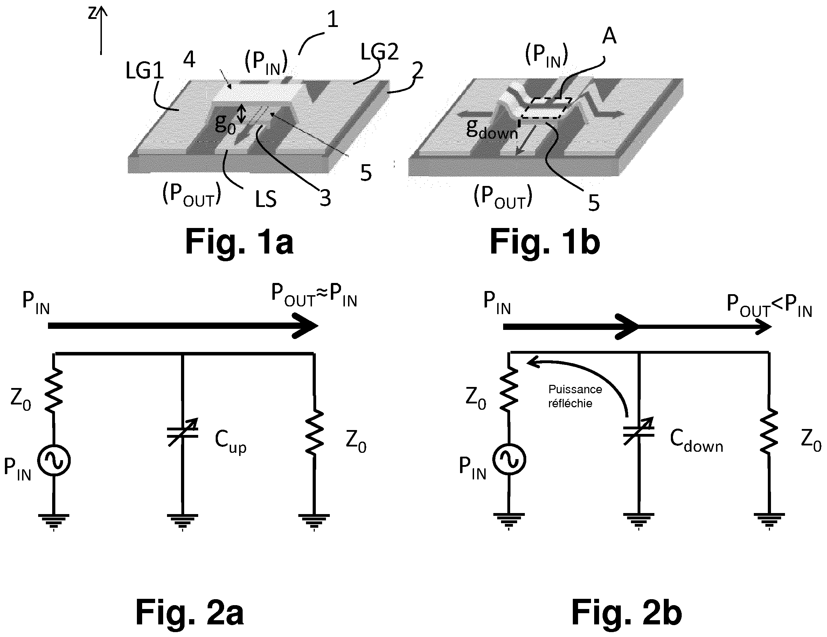

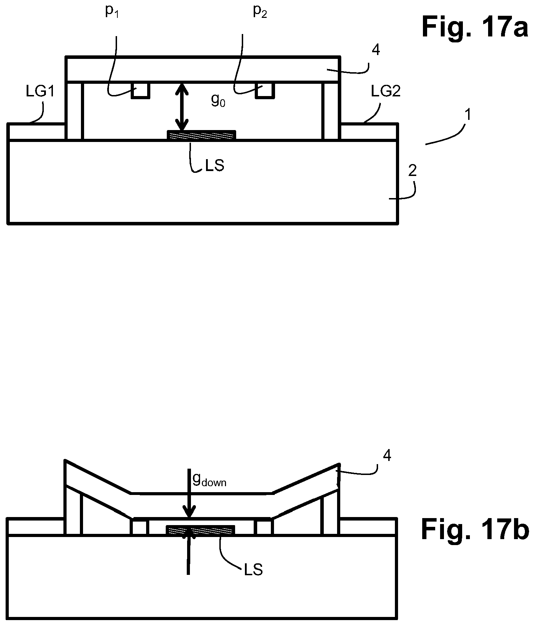

En pratique, un commutateur MEMS capacitif peut être à gap d'air : l'électrode mobile est placée au dessus de la ligne signal, comme illustré sur les vues en coupe des figures 17a et 17b, et des plots d'arrêt sont prévus, généralement sur l'électrode mobile, permettant d'imposer un gap minimal $g_{down}$ entre l'électrode mobile et la ligne signal, pour éviter un phénomène de collage de l'électrode mobile sur la ligne signal sous de fortes puissances de signal ; ou bien à contact capacitif : une couche de diélectrique est alors prévue sur la ligne signal, et à l'état bas, l'électrode mobile vient contre ce diélectrique. L'épaisseur du diélectrique donne la valeur du gap minimal $g_{down}$ qui à l'état bas, sépare l'électrode mobile de la ligne signal, comme illustré sur les vues de dessus des figures 1a et 1b.

Un exemple de commutateur MEMS RF capacitif est décrit en relation avec les figures 1a, 1b, 17a, 17b, qui correspondent à une technologie de fabrication coplanaire. Un commutateur MEMS RF capacitif 1 est formé sur un substrat 2, par exemple un substrat de silice fondue. La ligne de transmission du signal hyperfréquence, que l'on nomme plus commodément ligne signal LS par la suite, est réalisée sur le substrat ainsi qu'un plan de plan de masse électrique, comprenant dans l'exemple deux lignes de masse LG1, LG2, de part et d'autre de la ligne signal LS. Ces lignes LS, LG1 et LG2 sont typiquement réalisées en or.

Une électrode mobile 4 constituée d'un matériau conducteur, typiquement de l'or ou de l'Aluminium est formée au dessus de la ligne signal LS. Chaque extrémité de l'électrode mobile est reliée à une des lignes de masse LG1 et LG2. La surface inférieure de cette électrode mobile 4 est à une distance $g_0$ de la surface supérieure de ligne signal LS, qui forme dans la zone 3 sous l'électrode mobile, l'électrode d'actionnement du commutateur. La distance $g_0$ qui sépare l'électrode mobile à l'état haut de repos, et l'électrode d'actionnement ou ligne signal est encore appelé gap initial $g_0$ du commutateur MEMS.

De préférence, l'ensemble du commutateur MEMS est encapsulé de manière hermétique, sous vide.

On notera qu'un commutateur MEMS RF capacitif peut également être réalisé en technologie microruban, utilisant un substrat multicouche. Dans ce cas la ligne signal est réalisée sur une couche conductrice supérieure du substrat et le plan de masse sur une couche inférieure, et l'électrode mobile réalisée au-dessus de la ligne signal est reliée au plan de masse grâce à des vias pratiqués dans le substrat.

Sur les figures 17a et 17b qui illustrent un commutateur MEMS capacitif, dit à gap d'air, c'est-à-dire sans diélectrique, des plots d'arrêt $p_1$, $p_2$ sont prévus, dans l'exemple sur la membrane, en sorte d'assurer un gap minimum, $g_{down}$ entre la ligne signal LS et l'électrode mobile 4, lorsque celle-ci est actionnée à l'état bas (Figure 17b). Les deux électrodes ne doivent pas venir en contact l'une de l'autre.

Sur les figures 1a et 1b, le commutateur MEMS capacitif est à contact capacitif : le gap minimum $g_{down}$ entre l'électrode mobile et la ligne signal LS, lorsque l'électrode mobile est actionnée à l'état bas, correspond à l'épaisseur de la couche de diélectrique 5 prévue sur la ligne signal LS, dans la zone 3 formant l'électrode d'actionnement, sous l'électrode mobile.

Le principe du fonctionnement d'un commutateur MEMS RF capacitif utilisé en limiteur de puissance est maintenant expliqué en relation avec les schémas hyperfréquences équivalents du commutateur respectivement à l'état haut, figure 2a et à l'état bas, figure 2b. Les différentes formules qui sont données ci-après, qui expliquent ce fonctionnement sont celles d'un commutateur MEMS capacitif à gap d'air, comme illustré sur les figures 17a et 17b, dans lequel l'électrode mobile et la ligne signal sont séparées par de l'air, et plus particulièrement du vide. Mais toutes les explications données valent pour un commutateur MEMS du type à contact capacitif. Les formules seront simplement différentes, pour prendre en compte le diélectrique 5, et plus particulièrement la formule donnant la valeur de la capacité équivalente du commutateur lorsque l'électrode mobile est à l'état bas.

Ceci étant précisé, la ligne signal LS transporte le signal hyperfréquence, depuis l'entrée, en amont du commutateur vers l'aval. En amont du commutateur, le signal hyperfréquence arrive sur la ligne signal avec une puissance incidente $P_{IN}$. En aval du limiteur, le signal a une puissance de sortie $P_{OUT}$.

Quand l'électrode mobile 4 du commutateur MEMS radiofréquence est en position de repos, à l'état haut, tel qu'illustré sur la figure 17a ou la figure 1a, le gap entre l'électrode mobile et la ligne signal est $g_0$. Le commutateur MEMS radiofréquence est passant, et équivalent à une faible capacité $C_{up}$ entre la ligne signal et la masse. Le signal hyperfréquence incident est transporté sans pertes vers les éléments de la chaîne de traitement situés en aval du limiteur : $P_{out}$ est sensiblement égal à $P_{in}$.

La valeur $C_{up}$ est donnée par l'expression suivante :

$$C_{up} = \frac{\varepsilon_0 A}{g_0} \qquad\qquad (E1)$$

Avec :

- $\varepsilon_0$ : permittivité diélectrique du vide en farad par mètre (F/m),
- $A$ : surface en regard de l'électrode mobile 4 et de l'électrode d'actionnement 3, en mètre carré ($m^2$)
- $g_0$ : gap entre l'électrode mobile et l'électrode d'actionnement en mètre (m)
- $C_{up}$ en farad (F), qui est donc la valeur de la capacité équivalente du commutateur MEMS à l'état non commuté.

Lorsque la puissance incidente du signal hyperfréquence transporté par la ligne signal LS génère, au niveau de la zone 3 de ligne signal sous l'électrode mobile qui forme l'électrode d'actionnement du commutateur, une tension efficace $V_{RMS}$ qui est supérieure à la valeur de la tension d'actionnement continue (ou tension d'actionnement DC), $V_p$, du commutateur MEMS, la puissance dite d'auto-actionnement du commutateur est atteinte : la force électrostatique qui s'exerce de l'électrode mobile du commutateur MEMS radiofréquence vers la ligne LS est alors suffisante à déplacer l'électrode mobile 4 et l'amener dans son état bas caractérisé par le gap $g_{down}$ entre l'électrode mobile et la ligne signal, très inférieur au gap initial $g_0$. Cet état est celui illustré sur les figures 17b et 1b.

La tension d'actionnement $V_p$ du commutateur est caractéristique de la structure du commutateur et donnée de manière connue par l'expression suivante : $V_p = \sqrt{\frac{8kg_0^3}{27\varepsilon_0 A}}$ où k est la raideur du matériau formant l'électrode mobile 4 du commutateur.

Dans cet état bas, le commutateur MEMS radiofréquence est bloquant, équivalent à une forte capacité $C_{down}$ entre la ligne signal et la masse, de valeur plus élevée que celle de la capacité $C_{up}$, et donnée par l'expression suivante :

$$C_{down} = \frac{\varepsilon_0 A}{g_{down}} \qquad (E2)$$

(avec $g_{down}$ en mètre).

Dans le cas du commutateur capacitif, l'expression E2 est modifiée en remplaçant $g_{down}$ par $g_{down}$ sur $\varepsilon_r$ ($\varepsilon_r$ permittivité du diélectrique 5).

Le schéma électrique radiofréquence équivalent du commutateur est celui représenté sur la figure 2b. Le commutateur bloquant entraîne une désadaptation de la ligne signal : la puissance en excès est réfléchie par le commutateur. La puissance $P_{out}$ en sortie devient plus faible que la puissance $P_{in}$ en entrée.

Lorsque la puissance incidente du signal hyperfréquence retrouve des valeurs normales, l'électrode mobile 4 se relâche et retrouve son état haut, de repos.

Mais on a pu observer dans la pratique, un phénomène d'hystérésis entre l'actionnement, quand la puissance du signal hyperfréquence augmente et atteint ou dépasse une puissance d'actionnement, et le relâchement de l'électrode mobile lorsque la puissance du signal hyperfréquence redescend. Cette hystérésis est gênante. Aussi a t'on cherché à la comprendre.

La fréquence du signal hyperfréquence transporté par la ligne signal, et qui est en pratique de l'ordre de quelques GHz à plusieurs dizaines de GHz, est bien supérieure à la fréquence de résonance mécanique du commutateur MEMS, qui est de quelques MHz au maximum suivant l'état de l'art. Le commutateur MEMS est donc une structure avec un équilibre mécanique (c'est-à-dire qu'elle n'oscille pas naturellement). A l'équilibre, la force de rappel sur l'électrode mobile égale la force électrostatique.

La force de rappel est donnée par l'expression suivante:

$|F_r| = k(g_0 - g)$ avec k, coefficient de raideur de l'électrode mobile, et g la distance à laquelle l'électrode mobile se situe au-dessus de la ligne signal, correspondant sur la figure 1a à la position de l'électrode mobile 4 suivant l'axe z, relativement à la ligne signal LS, et $g_0$ étant la valeur de ce gap dans la position de repos (figure 1a).

La force électrostatique s'exprime comme suit:

$$|F_e| = \frac{C(g)V_{RMS}^2(P_{in}, C(g))}{2g}$$

avec C(g), la valeur de la capacité du commutateur MEMS, pour un gap g donné; $P_{in}$, la puissance disponible du signal hyperfréquence incident ; et $V_{RMS}$, la tension efficace aux bornes du commutateur MEMS pour cette puissance disponible et pour la valeur de capacité C(g) du commutateur MEMS.

A l'équilibre mécanique de la structure, les deux forces se compensent exactement ce qui donne l'égalité suivante :

$$k(g_0 - g) = \frac{C(g)V_{RMS}^2(P_{in}, C(g))}{2g} \qquad (E3)$$

De cet équilibre mécanique, il vient que l'on sait exprimer la puissance disponible $P_{in}$ du signal hyperfréquence incident au limiteur en fonction du gap g de la manière suivante :

$$P_{in} = \frac{k}{2Z_0\varepsilon_0 A}(g_0 - g)\left(4g^2 + Z_0^2\omega^2\varepsilon_0^2 A^2\right) \qquad (E4)$$

avec

- $Z_0$ : Impédances aux accès d'entrée/sortie du limiteur (Ohms) comme illustré sur les figures 2a et 2b

- ω : pulsation du signal hyperfréquence (radian/seconde)

Cette expression E4 montre que la puissance disponible du signal hyperfréquence incident au limiteur contrôle totalement la stabilité ou l'instabilité du MEMS radiofréquence et on peut montrer que l'équation $\frac{\delta P_{in}}{\delta g} = 0$ a bien deux solutions $g_1$ et $g_2$ qui sont les valeurs de gap pour lesquelles l'électrode mobile 4 du commutateur est instable, ce qui explique le phénomène d'hystérésis.

Les deux valeurs $g_1$ et $g_2$ sont données par les équations suivantes :

$$g_1 = \frac{g_0}{3} + \frac{g_0}{3}\sqrt{1 - \frac{3}{4}X} \qquad (E5)$$

$$g_2 = \frac{g_0}{3} - \frac{g_0}{3}\sqrt{1 - \frac{3}{4}X} \qquad (E6)$$

En posant $X = Z_0^2 \omega^2 \frac{\varepsilon_0^2 A_0^2}{g_0^2} = Z_0^2 \omega^2 C_{up}^2$

Le gap $g_1$ correspond à une instabilité lorsque la puissance disponible incidente augmente, correspondant ainsi à l'actionnement du commutateur et le gap $g_2$ correspond à une instabilité lorsque la puissance disponible incidente redescend, correspondant au relâchement du commutateur.

On voit que ces deux valeurs de gap dépendent notamment de la fréquence ω du signal hyperfréquence transporté par la ligne signal.

Pour $Z_0$ fixé, et un commutateur MEMS de caractéristiques données ($V_p$, $C_{up}$, $C_{down}$), on a en réalité trois modes de fonctionnement du commutateur MEMS RF, selon que la fréquence du signal hyperfréquence est inférieure, égale ou supérieure à la fréquence donnée par l'équation : $\omega = 2/(\sqrt{3}Z_0 C_{up})$.

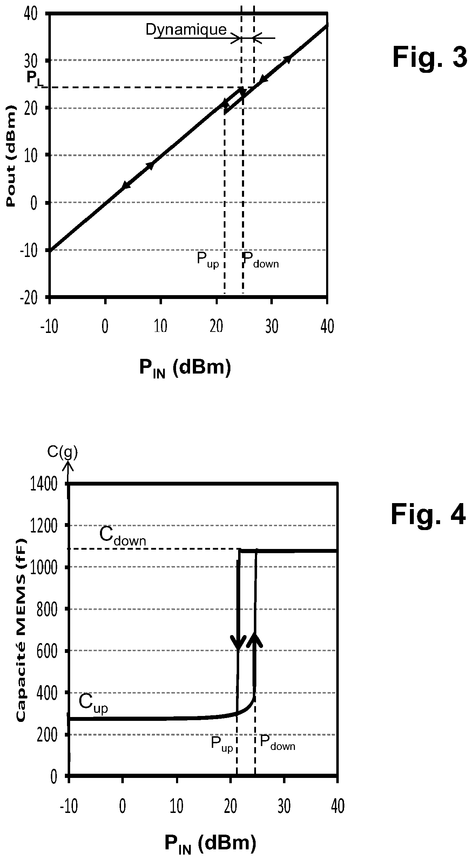

Ces trois modes de fonctionnement vont être décrits chacun en relation avec les figures 3 et 4 pour le premier, 5 et 6 pour le second, et 7 et 8 pour le troisième.

Pour illustrer ces trois modes de fonctionnement, on a choisi un limiteur avec une impédance $Z_0$ d'entrée et sortie égale à 50 ohms, et un commutateur MEMS RF ayant les paramètres caractéristiques suivants : une tension d'actionnement DC $V_p \left(= \sqrt{\frac{8kg_0^3}{27\varepsilon_0 A}}\right)$ égale à 3.5 volts ; une capacité $C_{up}$ (commutateur passant) égale à 270 fF ($10^{-15}$ Farads); et une capacité $C_{down}$ (commutateur bloquant) égale à 1080 fF. Pour cette structure, la valeur de fréquence donnée par l'équation $\omega = 2/(\sqrt{3}Z_0 C_{up})$ est égale à 13GHz.

Les figures 3, 5 et 7 représentent la puissance $P_{out}$ (en dBm) du signal hyperfréquence en sortie du limiteur, en fonction de la puissance incidente $P_{in}$ (en dBm) du signal hyperfréquence. Les figures 4, 6 et 8, représentent la variation de la capacité équivalente $C(g)$ du commutateur MEMS radiofréquence avec la puissance incidente $P_{in}$ du signal hyperfréquence en entrée du limiteur.

Le premier mode de fonctionnement est à hystérésis. Il correspond au cas où la fréquence ω est strictement inférieure à $2/(\sqrt{3}Z_0 C_{up})$ et il y a deux valeurs de gap inter armature, $g_1$ et $g_2$ pour lesquelles le système est instable, d'où l'hystérésis. Dans l'exemple illustré, ω=5GHz.

Le cycle d'actionnement/relâchement à hystérésis illustré sur les figures 3 et 4 est le suivant :
Quand la puissance incidente $P_{in}$ augmente, jusqu'à atteindre un niveau de puissance $P_{down}$ égal à 25dBm dans l'exemple, le commutateur MEMS radiofréquence s'actionne. La capacité du commutateur passe de la valeur initiale $C_{up}$ à la valeur $C_{down}$ (Figure 4). La puissance $P_{down}$ est la puissance d'auto-actionnement du commutateur. Sa valeur (en watts) est donnée par la valeur de puissance disponible $P_{in}$ en fonction de g, donnée par l'équation E4, en remplaçant g par l'expression E5 de la valeur $g_1$ :

$$P_{down} = P_{in}(g_1) = \frac{V_P^2}{2Z_0}\left[\left(1 + \frac{9}{4}X\right) + \left(\frac{4}{3} - \frac{9}{8}X\right)\sqrt{1 - \frac{3}{4}X} - \frac{1}{2}\left(1 - \frac{3}{4}X\right)^{3/2}\right] \qquad \text{(E7)}$$

Ainsi, lorsque la puissance incidente disponible augmente et atteint cette valeur $P_{down}$, le commutateur MEMS radiofréquence commute dans son état bas, dans lequel il est équivalent à la capacité $C_{down}$ (figures 1b et 2b).

Si la puissance incidente $P_{in}$ se met ensuite à diminuer, le commutateur ne se relâche que lorsque la puissance incidente atteint un niveau de puissance $P_{up}$ correspondant à la valeur $g_2$.

La puissance $P_{up}$ est la puissance de relâchement du commutateur. Sa valeur (en watts) est égale à la valeur de puissance disponible $P_{in}$ en fonction de g, donnée par l'équation E4, en remplaçant g par l'expression E6 de la valeur $g_2$ :

$$P_{up} = P_{in}(g_2) = \frac{V_P^2}{2Z_0}\left[\left(1 + \frac{9}{4}X\right) - \left(\frac{4}{3} - \frac{9}{8}X\right)\sqrt{1 - \frac{3}{4}X} + \frac{1}{2}\left(1 - \frac{3}{4}X\right)^{3/2}\right] \qquad \text{(E8)}$$

La puissance de relâchement $P_{up}$ est inférieure à la puissance d'actionnement $P_{down}$. Dans l'exemple, $P_{up}$ est égal à 21dBm. Avec le relâchement, l'électrode mobile retrouve son état haut de repos, et le commutateur retrouve sa valeur de capacité initiale $C_{up}$ (Figure 4).

Dans ce premier mode de fonctionnement, et comme illustré sur la figure 3, la dynamique du limiteur, qui est liée à la capacité du commutateur MEMS radiofréquence à réfléchir la puissance et donc à son contraste capacitif $C_{down}/C_{up}$ (dans l'exemple le ratio $C_{down}/C_{up}$ est de 4), s'étend de 25dBm (= $P_{down}$) à 27dBm. Cette dynamique correspond à la plage de puissance d'entrée, à partir de la valeur de $P_{down}$ jusqu'à une valeur maximum de puissance $P_{max}$, pour laquelle la puissance de sortie $P_{out}$ va rester égale ou sous une valeur limite PL. Dans l'exemple on a PL égale à 24dBm. Dans ce mode, les pertes d'insertion du commutateur ($P_{down}$-$P_L$), qui correspondent aux pertes par réflexion, sont égales à 1dBm.

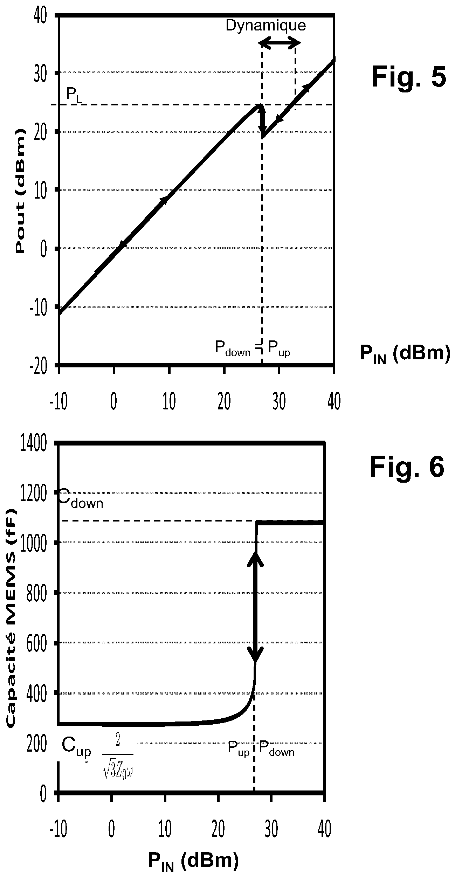

Le deuxième mode de fonctionnement illustré par les figures 5 et 6, correspond à la valeur particulière de fréquence $\omega$, pour laquelle, pour un commutateur donné, on va avoir $g_1=g_2$. Ceci est obtenu pour la fréquence de signal hyperfréquence donnée par l'équation $\omega = 2/\left(\sqrt{3}Z_0 C_{up}\right)$. On a alors $g_1=g_2=g_0/3$ (et X=4/3 dans E7 et E8). Avec les paramètres caractéristiques du commutateur MEMS pris en exemple, ceci donne $\omega$ égal à 13GHz.

Dans ce deuxième mode de fonctionnement, il n'y a qu'une seule valeur de gap inter armature, $g_1=g_2=g_0/3$, pour laquelle le système est instable, que la puissance monte, ou descende : la puissance d'auto-actionnement $P_{down}$ (l'expression E7) et la puissance de relâchement $P_{up}$ (expression E8) sont identiques (X=4/3). Leur expression est simplifiée pour ce mode de fonctionnement particulier.

$$P_{down} = P_{up} = \frac{2V_p^2}{Z_0}$$

La commutation est directe, donc abrupte comme visible sur les courbes $P_{out}$=f($P_{in}$) et C(g)=f($P_{in}$) représentées sur les figures 5 et 6. Il n'y a pas d'hystérésis. Le commutateur MEMS radiofréquence s'actionne et se relâche pour un niveau de puissance $P_{down}$ qui est ici de 27dBm, supérieur au niveau de la puissance d'actionnement dans le premier mode de fonctionnement (25dBm). La fréquence $\omega$ étant supérieure à celle du premier mode de fonctionnement (figures 4 et 5) la dynamique du limiteur est augmentée. Cette dynamique s'étend ici de 27dBm ($P_{down}$) à 34dBm. Mais cette augmentation de la dynamique s'accompagne d'une augmentation des pertes d'insertion : de l'ordre de 3dBm ici au lieu de 1dBm dans le cas de la figure 3.

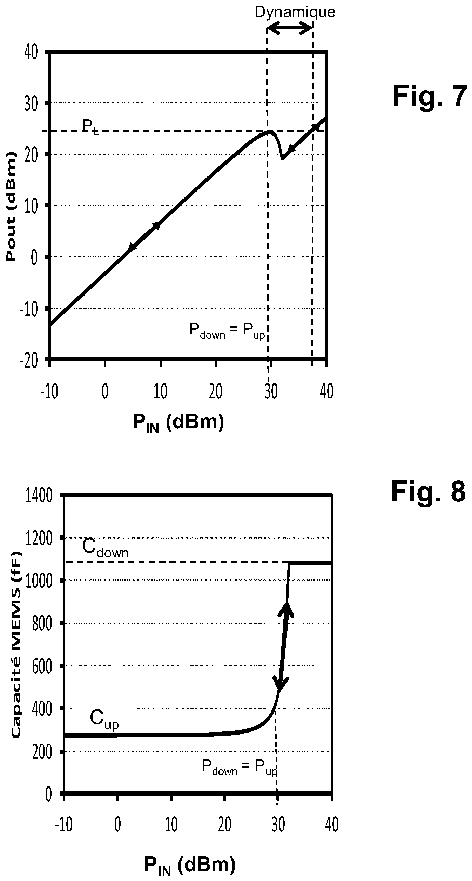

Le troisième mode de fonctionnement illustré par les figures 7 et 8 correspond au cas où la fréquence $\omega$ du signal hyperfréquence incident est supérieure à $2/\left(\sqrt{3}Z_0 C_{up}\right)$, et dans l'exemple, égale à 25GHz. Les expressions E5 et E6 des valeurs g1 et de g2 ne sont alors plus réelles, car les termes compris dans les racines carrées prennent des valeurs strictement négatives. Il n'y a pas d'instabilité mécanique dans le système, et donc pas d'hystérésis. A la commutation, la capacité MEMS radiofréquence C(g) passe de $C_{up}$ à $C_{down}$ ou inversement, suivant une loi de variation linéaire, analogique, en fonction de la puissance incidente $P_{in}$.

Plus particulièrement, dans l'exemple, le commutateur MEMS radiofréquence s'actionne pour un niveau de puissance $P_{down}$ qui dans l'exemple est de 30dBm, soit supérieur à celui obtenu dans les premier et deuxième modes de fonctionnement et à partir de cette puissance d'actionnement. La valeur de la capacité MEMS varie alors linéairement avec le niveau de puissance du signal hyperfréquence, jusqu'à $C_{down}$. Puisque la fréquence du signal considéré est plus grande que dans les deux premiers modes, la dynamique du limiteur est augmentée, partant de 30 dBm jusqu'à 39 dBm, mais les pertes d'insertion le sont également : 6 dBm.

Ces trois modes de fonctionnement d'un limiteur à commutateur MEMS radiofréquence mettent en évidence qu'il est théoriquement possible de concevoir un commutateur MEMS radiofréquence avec des paramètres caractéristiques tels que les conditions pour ne pas avoir d'hystérésis seront remplies, pour une pulsation $\omega$ de signal hyperfréquence donné. Cependant les pertes d'insertion (qui sont les pertes par réflexion) dans le limiteur seront plus élevées par rapport à un fonctionnement avec hystérésis de ce même commutateur (pour des signaux de fréquence moindre), et par voie de conséquence, la puissance nécessaire $P_{down}$ à l'actionnement est aussi plus élevée pour « compenser » l'augmentation des pertes d'insertion. Ces augmentations des pertes par insertion et de la puissance seuil du limiteur ne sont pas acceptables en pratique.

Une caractéristique importante des limiteurs est leur dynamique. La dynamique du limiteur à commutateur MEMS est liée à son contraste capacitif $C_{down}/C_{up}$, c'est-à-dire de la capacité du MEMS radiofréquence à désadapter la ligne de signal LS dans son état commuté. En comparant les trois modes de fonctionnement, on voit que cette dynamique augmente avec la fréquence du signal hyperfréquence, mais qu'elle reste faible.

Par ailleurs la puissance d'actionnement $P_{down}$ est liée à la tension d'actionnement DC $V_p$, comme on le voit de son expression indiquée précédemment (E7) et $V_p$ dépend des paramètres de conception du commutateur, dont l'étendue des valeurs possibles est fixée par l'état de l'art de la technologie.

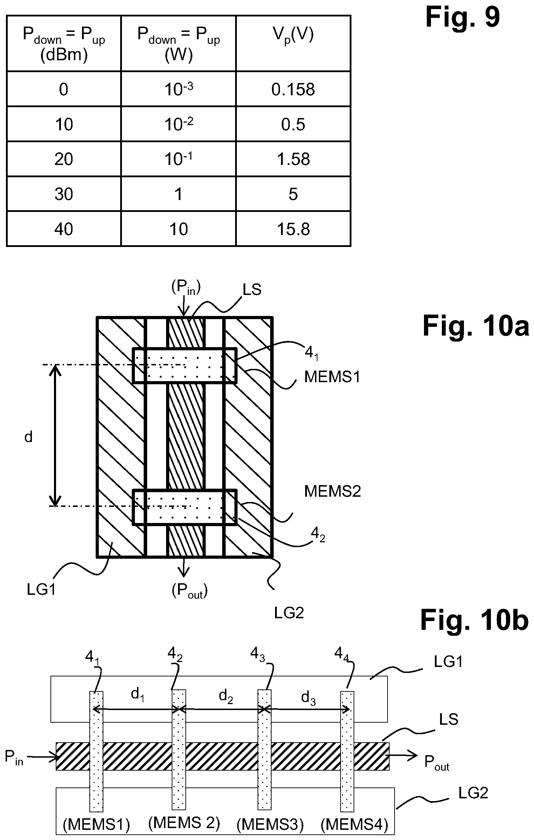

La figure 9 met en regard des valeurs des tensions d'actionnement DC $V_p$ pour un commutateur MEMS donné, les valeurs correspondantes de puissances d'actionnement $P_{down}$ pour un fonctionnement du limiteur sans hystérésis comme illustré sur les figures 5 et 6, soit pour $\omega = 2/\left(\sqrt{3}Z_0 C_0\right)$ équivalent à X=4/3.

Si on reprend l'exemple correspondant aux figures 5 et 6, le commutateur MEMS a une tension d'actionnement DC $V_p$=3.5V et la puissance d'actionnement sans hystérésis (2nd mode décrit supra) correspondante est de 27dBm. On a vu qu'avec un mode de fonctionnement avec hystérésis de ce même commutateur (1er mode décrit supra), la puissance d'actionnement serait plus basse, égale à 25dBm (figures 3 et 4).

Pour pouvoir atteindre des puissances d'actionnement sans hystérésis, il faut concevoir un commutateur MEMS RF avec une tension d'actionnement DC $V_p$ plus basse. Or les technologies actuelles permettent de descendre à des tensions d'actionnement de quelques volts. Il est ainsi difficile de descendre sous les 27 dBm de la figure 5, qui correspond déjà à une tension d'actionnement DC à la limite des possibilités technologiques actuelles.

Et si l'on souhaite pouvoir atteindre des puissances d'actionnement sans hystérésis encore plus basses, par exemple inférieures à 10dBm, il faudrait pouvoir concevoir un commutateur MEMS RF avec une tension d'actionnement DC $V_p$ de l'ordre de 0.5V.

L'article de X. Rottenberg et al. « MEMS Capacitive Series Switches : Optimal Test Vehicles for the RF Self-Biasing Phenomenon ». 18th IEEE International Conférence on Micro Electro Mechanical Systems 2005. pages 147-150. 2005 divulgue un commutateur MEMS RF capacitif ayant une électrode mobile de type poutre, qui permet, pour une tension d'activation donnée, de faire disparaître les hystérésis à une fréquence. Cependant, avec ce type de commutateur, si l'on souhaite à la fois faire disparaître les hystérésis et diminuer la fréquence du signal, il faut diminuer la puissance d'actionnement, donc diminuer la valeur de la tension d'actionnement, ce qui reste limité par les technologies actuelles.

RESUME DE L'INVENTION

L'invention a pour objet de proposer un limiteur de puissance d'un signal hyperfréquence de fréquence à base de commutateurs capacitifs offrant des performances améliorées, en particulier un fonctionnement sans hystérésis et une dynamique augmentée, permettant d'améliorer la protection des éléments électroniques placés en aval, d'une chaîne de traitement de signal hyperfréquence.

On a vu que l'on sait définir une structure de commutateur qui pour une fréquence signal donnée, aura un mode de commutation directe sans hystérésis (second mode décrit en relation avec les figures 5 et 6).

De manière surprenante, on a pu constater qu'en plaçant au moins deux commutateurs MEMS radiofréquences capacitifs en parallèle avec la ligne signal au lieu d'un seul, la dynamique du limiteur était augmentée. La ligne signal forme l'électrode d'actionnement des deux commutateurs en parallèle.

L'invention concerne donc un limiteur de puissance d'un signal hyperfréquence, comprenant une ligne signal de transport du signal hyperfréquence depuis une entrée du limiteur vers une sortie du limiteur, et au moins un premier et un deuxième commutateurs du type microsystème électromécanique radiofréquence capacitif chacun en parallèle entre la ligne signal et un plan de masse, où la ligne signal forme une électrode d'actionnement électrostatique de chacun des commutateurs, caractérisé en ce que le premier commutateur a un mode de commutation direct sans hystérésis à la fréquence ω du signal hyperfréquence appliqué en entrée du limiteur, et le deuxième commutateur du même type que le premier, est placé en aval du premier commutateur et a une même tension d'actionnement continue.

Le limiteur peut comprendre en variante, une pluralité de commutateurs, chacun en parallèle avec la ligne signal, de même type et de même tension d'actionnement continue que le premier commutateur, tels que pour chacun de cette pluralité de commutateurs, le niveau de la puissance incidente au limiteur qui est nécessaire à l'actionnement d'un commutateur est supérieur au niveau de la puissance incidente au limiteur qui est nécessaire à l'actionnement du commutateur placé immédiatement en amont de lui, sur la ligne signal.

Avantageusement, tous les commutateurs du limiteur sont identiques.

La structure du premier commutateur est telle qu'à la fréquence du signal hyperfréquence appliqué en entrée du limiteur, le premier commutateur a un mode de commutation directe sans hystérésis.

Dans un premier perfectionnement, une résistance est placée en série avec l'électrode mobile de chacun des commutateurs du limiteur, la résistance ayant une valeur identique pour tous les commutateurs. On réalise alors un limiteur, avec absorption de l'excès de puissance.

Dans un autre perfectionnement, le limiteur comprend un circuit de polarisation continue entre la ligne signal LS et les plans de masse LG1 et LG2, permettant de diminuer le niveau de la tension rms d'actionnement électrostatique nécessaire pour activer la commutation.

D'autres caractéristiques et avantages de l'invention sont détaillés dans la description détaillée suivante, faite en référence aux dessins annexés, dans lesquels :

- les figures 1a et 1b déjà décrites sont des vues de dessus d'un commutateur MEMS radiofréquence capacitif, du type à contact capacitif utilisé en limiteur de puissance d'un signal hyperfréquence ;
- les figures 2a et 2b déjà décrites illustrent les effets sur la puissance de sortie d'un commutateur MEMS radiofréquence capacitif, en fonction de la puissance incidente du signal hyperfréquence ;
- les figures 3 et 4 déjà décrites représentent les courbes de la puissance de sortie et de la capacité d'un limiteur à commutateur MEMS radiofréquence capacitif, en fonction de la puissance incidente, dans un mode de fonctionnement à hystérésis ;
- les figures 5 et 6 déjà décrites représentent ces mêmes courbes dans un mode de fonctionnement sans hystérésis ;
- les figures 7 et 8 déjà décrites représentent ces mêmes courbes dans un autre mode de fonctionnement sans hystérésis ;
- la figure 9 est un tableau illustrant la correspondance entre tension d'actionnement DC $V_p$ d'un commutateur MEMS et les puissances minimales d'actionnement et de relâchement sans hystérésis du limiteur ;
- la figure 10a illustre de façon schématique, en vue de dessus, un limiteur à deux commutateurs MEMS capacitif selon l'invention, et la figure 10b, une généralisation à plus de deux commutateurs ;
- les figures 11a, 11b et 11c sont les schémas électriques radiofréquence de ce limiteur, en fonction du niveau de puissance incidente avec les effets sur la puissance de sortie de ce commutateur ;
- les figures 12a et 12b illustrent chacune une courbe de la puissance de sortie d'un limiteur selon l'invention, en fonction de la puissance incidente, pour les structures illustrées aux figures 10a et 10b ;
- les figures 13a et 13b illustrent un limiteur selon un premier perfectionnement de l'invention considéré respectivement en vue de dessus et en vue en coupe ;
- les figures 14a à 14c sont des schémas électriques radiofréquences équivalents de ce limiteur illustrant les effets sur la puissance de sortie en fonction de la puissance incidente du signal hyperfréquence ;
- la figure 15 est la courbe de la puissance de sortie d'un limiteur selon le premier perfectionnement de l'invention, en fonction de la puissance incidente ;
- la figure 16 est un schéma électrique représentant un limiteur selon un deuxième perfectionnement de l'invention ; et
- les figures 17a et 17b déjà décrites sont des vues en coupe simplifiées d'un commutateur MEMS capacitif, à gap d'air, utilisé en limiteur de puissance d'un signal hyperfréquence.

DESCRIPTION DETAILLEE DE L'INVENTION

Comme illustré sur les figures 10a et 10b, un limiteur selon l'invention comprend une mise en cascade de plusieurs commutateurs MEMS radiofréquence capacitifs, au moins deux, parallèles à la ligne signal LS. Les commutateurs ne sont pas nécessairement placés à équidistance les uns des autres. La distance entre les commutateurs est choisie en fonction du besoin de l'application, afin d'obtenir de bonnes performances, c'est-à-dire tout à la fois:

- engendrer un minimum de pertes lorsque les commutateurs ne sont pas actionnés ;
- engendrer suffisamment de pertes par réflexion lorsque les commutateurs sont actionnés sous l'effet d'une forte puissance du signal hyperfréquence traversant la ligne LS ;

- permettre l'actionnement des commutateurs pour une puissance de limitation $P_L$ (en sortie du limiteur) qui soit identique pour chacun des commutateurs.

En pratique, la distance entre les commutateurs est optimisée pour l'application considérée, typiquement par simulation : elle dépend notamment de la fréquence du signal hyperfréquence appliqué au limiteur, de la valeur des capacités MEMS dans leur état initial...

La figure 10a est une vue détaillée d'une mise en œuvre de l'invention avec deux commutateurs MEMS radiofréquences capacitifs, un premier MEMS1 et un deuxième MEMS2 placé à une distance d du premier. Les deux commutateurs MEMS1, MEMS2, ont chacun leur électrode mobile supérieure, $4_1$, $4_2$, au-dessus de la ligne signal LS qui transporte le signal hyperfréquence d'une entrée, en amont du premier commutateur MEMS1, vers une sortie, en aval du deuxième commutateur MEMS2. Ces commutateurs ont dans l'exemple la même structure que celle décrite en relation avec les figures 1a et 2a. Pour simplifier, on a repris les mêmes références pour les différents éléments, affectées d'un indice, égal à 1 ou 2, signalant leur appartenance au premier commutateur MEMS1, ou au deuxième, MEMS2. On a ainsi notamment les électrodes mobiles $4_1$ et $4_2$.

La distance d entre les deux commutateurs, est la distance entre leurs électrodes mobiles $4_1$ et $4_2$, comme indiqué sur la figure.

Les deux commutateurs MEMS1 et MEMS2 ont la même tension d'actionnement DC $V_p$, de manière à ce que la puissance de limitation en sortie de chaque commutateur quand il s'actionne, soit sensiblement la même, égale à $P_L$. Ils sont de préférence conçus pour que si on les considère chacun indépendamment, ils aient un fonctionnement sans hystérésis à commutation directe à la fréquence signal considérée, correspondant au second mode de fonctionnement décrit en relation avec les figures 5 et 6, et ils ont de préférence une structure identique.

Il est à noter que dans la présente invention, l'expression "même tension d'actionnement (Vp)", s'entend de la valeur nominale de cette tension. Les tensions réelles d'actionnement des commutateurs Mems du limiteur peuvent en pratique avoir des valeurs qui s'écartent de cette valeur nominale. Ces écarts seront suffisamment faibles, de préférence inférieurs à dix pour cent, pour que le limiteur assure l'effet technique recherché, à savoir écrêter le signal RF avec une puissance de sortie constante ou quasi-constante sur une large dynamique. De préférence, le limiteur est tel que le commutateur qui doit s'actionner avant un deuxième commutateur suivant le mode de fonctionnement décrit dans l'invention ait la tension (réelle) d'actionnement la plus faible. Ceci peut être obtenu en triant les limiteurs en fonction de ce critère.

Le fonctionnement de ce limiteur à deux commutateurs selon l'invention, illustré à la figure 10a, est expliqué pour ces conditions préférées, à savoir, les deux commutateurs MEMS1 et MEMS2 ont une structure identique prévue pour fonctionner dans un limiteur à unique commutateur, en commutation directe sans hystérésis correspondant au second mode de commutation décrit en relation avec les figures 5 et 6, pour la fréquence du signal hyperfréquence considéré. Pour les besoins de simulation et d'optimisation, on choisit une structure de MEMS correspondant à celle utilisée précédemment pour expliquer les différents modes de fonctionnement du commutateur utilisé seul en limiteur, en relation avec les figures 3 à 8, soit une structure avec les caractéristiques suivantes : $V_p$=3,5 volts, $C_{up}$= 270fF, $C_{down}$=1080fF, la fréquence signal $\omega = 2/\left(\sqrt{3}Z_0 C_{up}\right)$ pour laquelle le second mode de commutation est obtenu (commutation directe sans hystérésis), est égale à 13GHz (avec une impédance d'entrée et de sortie du limiteur de 50 ohms).

Dans la structure de limiteur selon l'invention, comme décrite en relation avec la figure 10a, même s'ils ont une structure identique, les deux commutateurs ne se comportent pas de manière identique.

En effet, chacun utilisé seul comme limiteur, comme dans le schéma de la figure 5, aurait exactement la même réponse à la puissance du signal hyperfréquence. Notamment, il s'actionnerait pour le même niveau $P_{down}$ (figure 6) de puissance incidente. Cependant, lorsqu'on les cascade dans un limiteur selon l'invention, afin d'augmenter la dynamique, leur fonctionnement diffère. Le premier commutateur MEMS1 est celui qui voit « en premier » la puissance incidente (Pin) et donc c'est lui qui s'actionne en premier sous l'effet d'un niveau $P_{down1}$ de puissance incidente P à ses bornes, égal à sa puissance seuil d'actionnement.

Le deuxième commutateur ne « voit » pas à ce moment assez de puissance pour s'actionner, à cause du temps de propagation du signal entre le premier et le deuxième commutateur, des pertes dans la ligne de propagation de signal entre le premier et le deuxième commutateur et de l'actionnement du premier commutateur qui induit une diminution de puissance perçue par le deuxième commutateur. Ainsi, le deuxième commutateur s'actionne pour un niveau $P_{down2}$ de puissance incidente au limiteur pour lequel le second commutateur perçoit une puissance à ses bornes égale à sa puissance d'actionnement (qui est égal à $P_{down1}$ lorsque les deux commutateurs sont identiques).

En d'autres termes, les différents commutateurs dans l'architecture de limiteur selon l'invention ne perçoivent pas les mêmes impédances.

Ainsi, à la fréquence du signal hyperfréquence, 13 GHz, pour la structure de commutateur indiquée plus haut,

EP 2 648 335 B1

le premier commutateur MEMS1 a un mode de fonctionnement sans hystérésis à commutation directe, et le second commutateur MEMS2 a un mode de fonctionnement sans hystérésis à capacité variable.

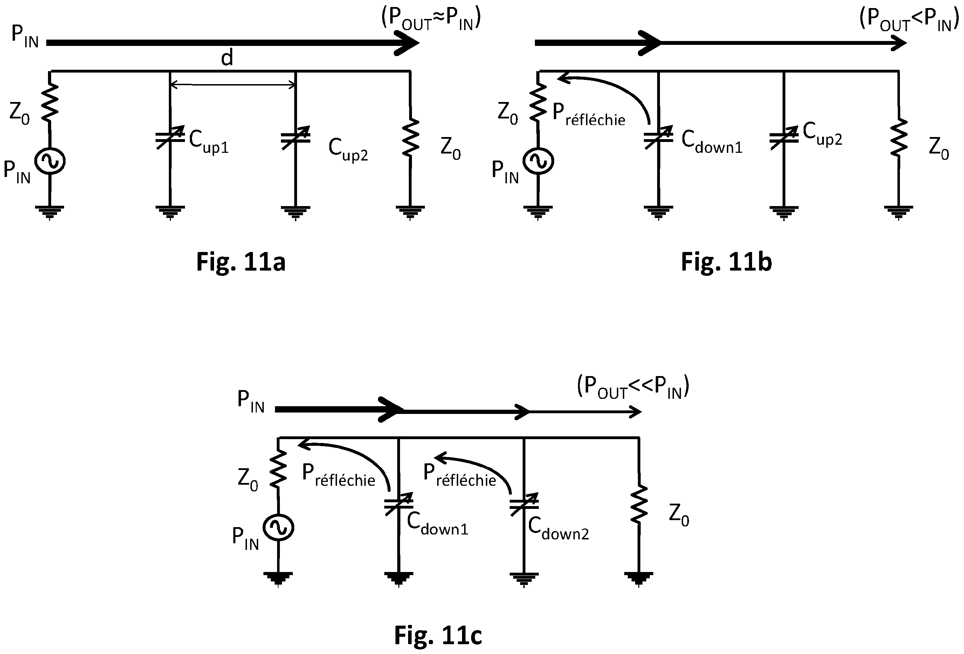

La figure 11a montre le schéma radiofréquence correspondant du limiteur, lorsque la puissance incidente $P_{in}$ du signal hyperfréquence est inférieure à la puissance d'actionnement du premier commutateur. Les 2 commutateurs MEMS1 et MEMS2 sont à l'état haut, passant, représenté par leur capacité dans cet état, notée respectivement $C_{up1}$ et $C_{up2}$. Toute la puissance du signal hyperfréquence est transmise en sortie sans pertes.

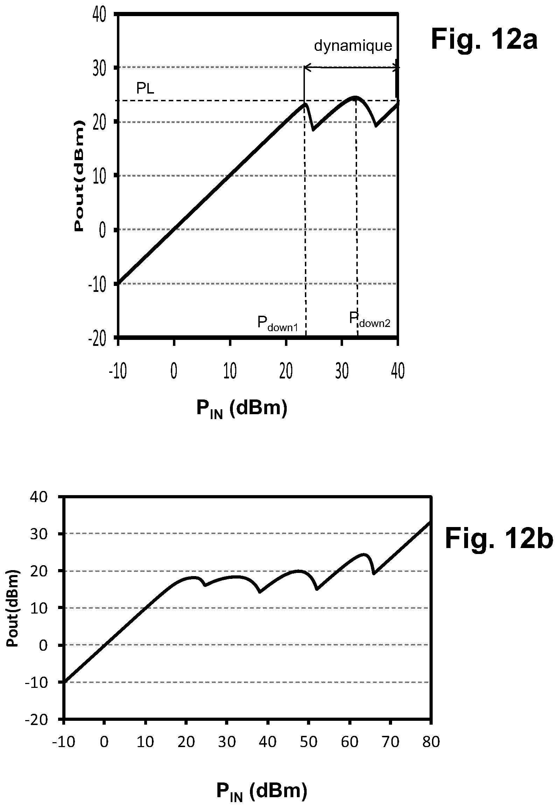

Comme illustré sur la courbe de réponse du limiteur, figure 12a, lorsque la puissance incidente $P_{in}$ du signal hyperfréquence augmente et atteint la puissance d'actionnement $P_{down1}$ du premier commutateur MEMS1, celui-ci s'actionne, devenant équivalent à la capacité notée $C_{down1}$, et réfléchit alors une partie de la puissance vers l'entrée du limiteur. Le schéma radiofréquence correspondant est celui représenté sur la figure 11b. Le commutateur MEMS2 ne change pas d'état ($C_{up2}$).

Si la puissance incidente du signal hyperfréquence continue d'augmenter et atteint le niveau $P_{down2}$, le deuxième commutateur MEMS2 s'actionne, devenant équivalent à la capacité notée $C_{down2}$, et réfléchit également une partie de la puissance en amont du limiteur. Le schéma radiofréquence correspondant est celui représenté sur la figure 11c.

On voit clairement sur la figure 12a que la dynamique du limiteur est augmentée, comparée à celle du limiteur avec un seul commutateur dans le mode de fonctionnement à commutation directe sans hystérésis (Figure 5).

Cette dynamique est encore améliorée si on ajoute d'autres commutateurs. La figure 10b illustre ainsi une généralisation d'un limiteur selon l'invention, à plus de deux commutateurs, dans l'exemple quatre, notés MEMS1 à MEMS4 des commutateurs. Le commutateur MEMS2 est placé à une distance d1 du premier, MEMS1. Le commutateur MEMS3 est placé à une distance d2 du second, MEMS2. Le commutateur MEMS4 est placé à une distance d3 du troisième, MEMS3.

La figure 12b montre l'allure de la courbe de réponse correspondante, obtenue par simulation, pour un signal hyperfréquence de fréquence 13 GHz et dans une configuration du limiteur de la figure 10b dans laquelle les quatre commutateurs ont une structure identique, correspondante à celle indiquée précédemment (avec $V_p$=3,5 volts, $C_{up}$= 270fF, $C_{down}$=1080fF) et sont placés à équidistance les uns des autres, à une distance optimisée par simulation (d1=d2=d3), égale à $2800.10^{-6}$m, et une impédance d'entrée et de sortie du limiteur égale à 50 ohms. Cette courbe montre une très bonne augmentation de la dynamique. On observe en pratique et de manière surprenante une diminution légère de la puissance d'actionnement, ce qui est un effet favorable.

Ainsi, l'insertion d'un ou plusieurs commutateurs en aval d'un premier commutateur MEMS RF placé à l'entrée du limiteur, ayant tous la même tension d'actionnement continue $V_p$, permet d'augmenter la dynamique du limiteur, et peut tendre à faire baisser le niveau de puissance nécessaire à l'actionnement des commutateurs.

Comme on sait concevoir une structure de commutateur MEMS pour laquelle, à la fréquence de signal hyperfréquence de l'application, un commutateur MEMS FR capacitif seul aura un fonctionnement du type à commutation directe sans hystérésis, un limiteur selon l'invention comprendra de préférence des commutateurs avec une structure correspondante. Comme expliqué précédemment, lorsque ces commutateurs sont insérés dans le limiteur, seul le premier conserve ce mode de fonctionnement. Les autres commutateurs insérés en aval du premier commutateur se comportent différemment, c'est-à-dire non pas en commutation directe, mais, à la commutation, en capacité variable avec le niveau de puissance incidente, en partie pour les raisons expliquées supra (perception d'impédances différentes).

Comme indiqué précédemment, les courbes de réponse des limiteurs présentées sur les figures 12a et 12b, obtenues par simulation, correspondent à des limiteurs utilisant des commutateurs ayant tous la même structure : les conditions d'optimisation et de simulation sont plus simples, et ce sont aussi en pratique des limiteurs plus simples à fabriquer.

Mais l'invention ne se limite pas à des limiteurs dans lesquels les commutateurs seraient nécessairement tous identiques. Ils doivent seulement être de même type, c'est-à-dire que ce sont tous des commutateurs MEMS RF capacitifs, et avoir tous la même tension d'actionnement continue Vp.

La distance entre deux commutateurs est en pratique optimisée, par simulation, pour obtenir la meilleure réponse du limiteur. Dans le cas d'un limiteur à plus de deux commutateurs, comme illustré sur la figure 10b dans une configuration à 4 commutateurs, ceux-ci ne sont pas nécessairement équidistants, c'est à dire que les valeurs de d1, d2 et d3 peuvent être différentes. L'optimisation de la distance entre deux commutateurs du limiteur est réalisée par simulation, et dépend notamment de la fréquence du signal hyperfréquence, et des valeurs des capacités à l'état initial, non commuté, des commutateurs (capacités $C_{up}$).

Les commutateurs du limiteur peuvent être du type à air gap ou à contact capacitif. On comprend que pour la simplicité de la conception et la fabrication d'un limiteur selon l'invention, les commutateurs du limiteur seront soit tous à air gap, soit tous à contact capacitif.

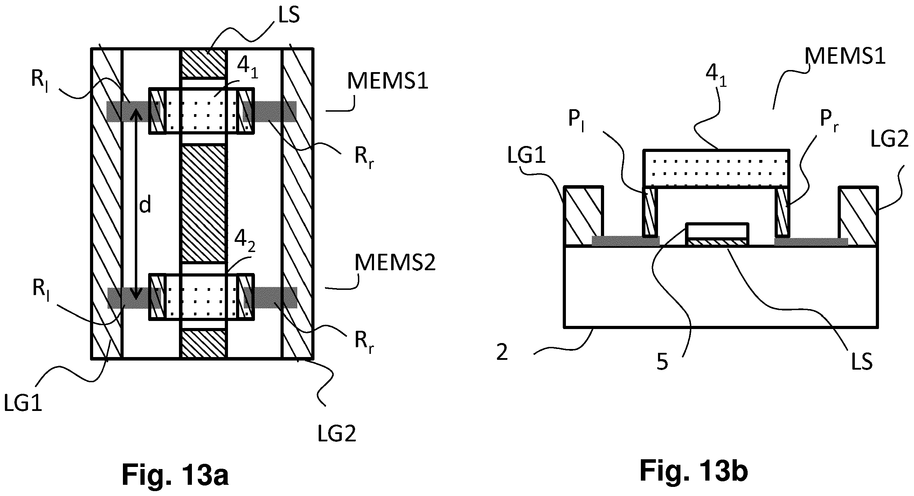

Les figures 13a et 13b sont des vues de dessus et en coupe d'un limiteur à deux commutateurs MEMS selon l'invention, qui illustrent un premier perfectionnement de l'invention, permettant l'absorption de la puissance en excès plutôt que la réflexion.

La structure du limiteur correspond à celle déjà expliquée en relation avec la figure 10a, pour des commutateurs MEMS RF à contact capacitif : un diélectrique 5 est ainsi placé sur la ligne signal LS, sous l'électrode mobile de chaque commutateur.

Ce perfectionnement consiste à placer en série avec l'électrode mobile $4_1$ et $4_2$ de chaque commutateur MEMS$_1$ et MEMS$_2$, une résistance qui a la même valeur pour les deux commutateurs, qu'ils soient identiques ou non. La valeur de la résistance est choisie en fonction de la puissance que l'on veut pouvoir dissiper au travers, quand le commutateur est actionné. Quand le commutateur est passant, la résistance ne doit pas engendrer de pertes. En pratique, une valeur de 50 ohms sera généralement satisfaisante.

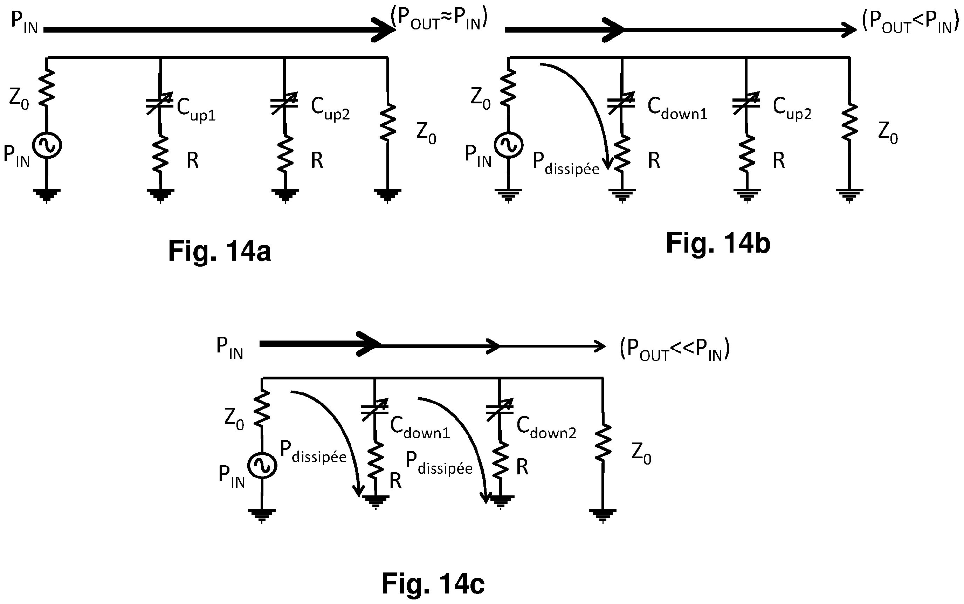

Les figures 14a à 14c sont les schémas électriques radiofréquences correspondants montrant les effets sur la puissance de sortie, selon le niveau de la puissance incidente du signal hyperfréquence. Là où la puissance était réfléchie dans les figures 11b et 11c, elle est maintenant absorbée par les résistances.

Dans l'exemple illustré la résistance est réalisée par exemple avec du silice de chrome ou du carbone dopé Nickel, déposé sur le substrat, en deux pavés $R_l$ et $R_r$ disposés de part et d'autre et isolés de la ligne signal LS, en une épaisseur de quelques dizaines à quelques centaines de nanomètres. Les lignes de masse LG1 et LG2 sont formées après, et recouvrent le bord de la résistance opposé au bord côté ligne signal. L'électrode mobile $4_1$, $4_2$, repose à chaque extrémité sur des piliers $P_l$ et $P_r$ en matériau conducteur, typiquement de l'or, formés de part et d'autre de la ligne signal LS, sur le bord des résistances, côté ligne signal. Les piliers auront par exemple une épaisseur de 0.3 à 1 $\mu$m.

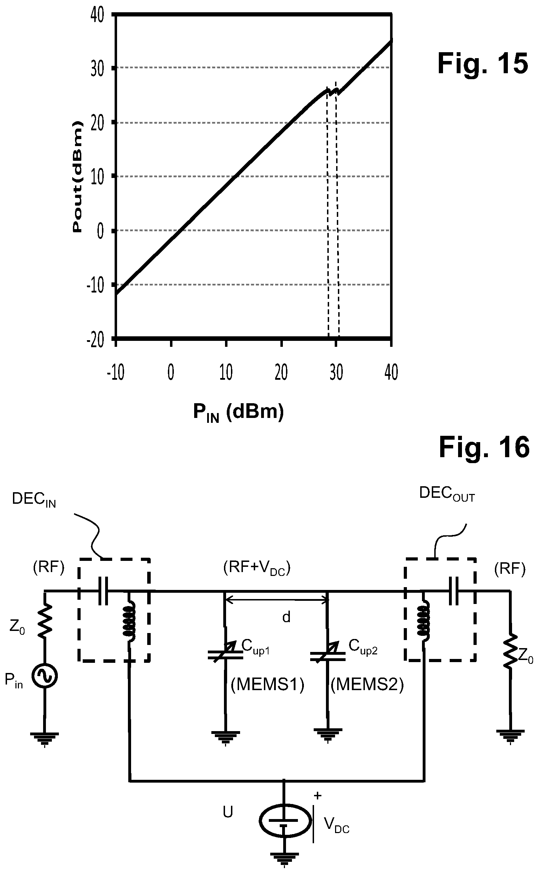

La courbe de la figure 15 illustre la puissance de sortie $P_{out}$ du limiteur en fonction de la puissance d'entrée pour un signal hyperfréquence de 18GHz. Elle est obtenue par simulation en prenant deux commutateurs de structure identique, qui est celle déjà indiquée (avec $V_p$ = 3.5V, $C_{up}$ =70fF et $C_{down}$ = 290fF), dans un limiteur à impédance d'entrée et de sortie 50 ohms, et des résistances R de valeur 50 ohms. On notera qu'en pratique, la valeur $C_{up}$ des commutateurs MEMS doit être suffisamment faible (70fF ici), pour que le signal hyperfréquence ne soit pas dissipé dans les résistances lorsque les commutateurs ne sont pas actionnés.

Un deuxième perfectionnement de l'invention est illustré sur la figure 16. On a vu que la tension d'actionnement continue $V_p$ d'un commutateur est fonction de la structure du commutateur et que l'on ne peut abaisser son niveau que dans les limites permises par les technologies et matériaux utilisés. Le deuxième perfectionnement permet de contourner ces limites en permettant d'abaisser la puissance d'auto-actionnement nécessaire à actionner les commutateurs. Ceci est obtenu par l'application sur la ligne signal, d'une tension de polarisation continue, qui vient ainsi s'ajouter à la tension RMS due à la puissance du signal hyperfréquence transporté par la ligne signal. Elle permet par exemple d'abaisser la puissance d'auto-actionnement des commutateurs autour de 10dBm, en utilisant une tension de polarisation continue $V_{DC}$ de l'ordre de 2 volts.

La réalisation pratique comprend une source de tension continue, U, placée sur la ligne de signal LS, et qui fournit une tension continue $V_{DC}$.

Pour assurer le découplage du signal continu $V_{DC}$ du signal hyperfréquence, la source U est connectée à la ligne signal LS via un circuit de découplage, communément appelé "Té de polarisation", à résistance et inductance, en entrée (circuit DEC$_{IN}$) et en sortie (circuit DEC$_{OUT}$) du limiteur.

Les différentes variantes et perfectionnements décrits et/ou illustrés peuvent se combiner entre eux, permettant de concevoir des limiteurs efficaces et performants adaptés à de nombreuses applications.

L'invention a été plus particulièrement décrite en présentant des limiteurs à commutateurs MEMS RF capacitifs réalisés en technologie coplanaire, mais on a vu que ces limiteurs peuvent aussi bien être réalisés en technologie microruban.

**Revendications**

1. Limiteur de puissance d'un signal hyperfréquence, comprenant une ligne signal (LS) de transport du signal hyperfréquence depuis une entrée du limiteur vers une sortie du limiteur, et au moins un premier et un deuxième commutateurs du type microsystème électromécanique radiofréquence capacitif chacun en parallèle entre la ligne signal (LS) et un plan de masse, où la ligne signal forme une électrode d'actionnement électrostatique de chacun des commutateurs, **caractérisé en ce que** le premier commutateur a un mode de commutation direct sans hystérésis à la fréquence $\omega$ du signal hyperfréquence appliqué en entrée du limiteur, et le deuxième commutateur (MEMS2) du même type que le premier, est placé en aval du premier commutateur et a une même tension d'actionnement continue ($V_p$).

2. Limiteur de puissance hyperfréquence selon la revendication 1, comprenant une pluralité de commutateurs (MEMS2, MEMS3, MEMS4) en parallèle, de même type et de même tension d'actionnement continue ($V_p$) que le premier commutateur (MEMS1).

3. Limiteur de puissance hyperfréquence selon la revendication 1 ou 2, dans lequel les commutateurs du limiteur sont tous identiques.

4. Limiteur de puissance hyperfréquence selon l'une quelconque des revendications précédentes, chaque commutateur du limiteur comprenant une électrode mobile ($4_1$, $4_2$) au dessus de la ligne signal (LS), **caractérisé en ce que** chaque commutateur du limiteur comprend une résistance (R) de valeur identique en série avec son électrode mobile et la masse.

5. Limiteur de puissance hyperfréquence selon l'une quelconque des revendications précédentes, **caractérisé en ce qu'**il comprend en outre une source (U) de tension continue ($V_{DC}$) sur la ligne signal (LS) du limiteur.

6. Limiteur de puissance hyperfréquence selon la revendication précédente, dans lequel ladite source de tension est reliée à la ligne signal en entrée et en sortie du limiteur, via un circuit de découplage ($DEC_{IN}$, $DEC_{OUT}$) de la tension continue, du signal hyperfréquence.

7. Dispositif électronique de traitement d'un signal hyperfréquence comprenant un limiteur de puissance selon l'une quelconque des revendications 1 à 6, placé en amont de circuits de traitement du signal.

**Patentansprüche**

1. Hyperfrequenzsignal-Leistungsbegrenzer, umfassend eine Signalleitung (LS) zum Transportieren des Hyperfrequenzsignals von einem Eingang des Begrenzers zu einem Ausgang des Begrenzers und wenigstens einen ersten und einen zweiten Schalter vom Typ eines kapazitiven elektromechanischen Radiofrequenz-Mikrosystems, jeweils parallel zwischen der Signalleitung (LS) und einer Masseebene geschaltet, wobei die Signalleitung eine elektrostatische Betätigungselektrode für jeden der Schalter hat, **dadurch gekennzeichnet, dass** der erste Schalter einen direkten Schaltmodus ohne Hysterese auf der Frequenz ω des am Eingang des Begrenzers angelegten Hyperfrequenzsignals hat, und der zweite Schalter (MEMS2) desselben Typs wie der erste unterhalb des ersten Schalters platziert ist und dieselbe Betätigungsgleichspannung ($V_p$) hat.

2. Hyperfrequenzleistungsbegrenzer nach Anspruch 1, der mehrere parallel geschaltete Schalter (MEMS2, MEMS3, MEMS4) desselben Typs und mit derselben Betätigungsgleichspannung ($V_p$) hat wie der erste Schalter (MEMS1).

3. Hyperfrequenzleistungsbegrenzer nach Anspruch 1 oder 2, bei dem die Schalter des Begrenzers alle identisch sind.

4. Hyperfrequenzleistungsbegrenzer nach einem der vorherigen Ansprüche, wobei jeder Schalter des Begrenzers eine bewegliche Elektrode ($4_1$, $4_2$) über der Signalleitung (LS) hat, **dadurch gekennzeichnet, dass** jeder Schalter des Begrenzers einen Widerstand (R) mit identischem Wert in Serie mit seiner beweglichen Elektrode und der Masse hat.

5. Hyperfrequenzleistungsbegrenzer nach einem der vorherigen Ansprüche, **dadurch gekennzeichnet, dass** er ferner eine Quelle (U) für Gleichspannung ($V_{DC}$) auf der Signalleitung (LS) des Begrenzers hat.

6. Hyperfrequenzleistungsbegrenzer nach dem vorherigen Anspruch, wobei die Spannungsquelle mit der Signalleitung am Eingang oder am Ausgang des Begrenzers über eine Entkopplungsschaltung ($DEC_{IN}$, $DEC_{OUT}$) der Gleichspannung des Hyperfrequenzsignals verbunden ist.

7. Elektronische Vorrichtung zum Verarbeiten eines Hyperfrequenzsignals, umfassend einen Leistungsbegrenzer nach einem der Ansprüche 1 bis 6, platziert oberhalb von Signalverarbeitungsschaltungen.

**Claims**

1. Hyper-frequency signal power limiter, comprising a signal line (LS) for transporting the hyper-frequency signal from an input of the limiter to an output of the limiter, and at least a first and a second commutator of the capacitive radiofrequency micro-electro-mechanical system type, each one in parallel between the signal line (LS) and an earth plane, where the signal line forms an electrostatic activation electrode of each of the commutators, **characterised in that** the first commutator has a direct commutation mode without hysteresis at the frequency co of the hyperfrequency signal applied at the input of the limiter, and the second commutator (MEMS2) of the same type as the first is placed downstream of the first commutator and has the same direct activation voltage ($V_p$).

2. Hyper-frequency power limiter according to claim 1, comprising a plurality of commutators (MEMS2, MEMS3, MEMS4) in parallel of the same type and having the same direct activation voltage (Vp) as the first commutator (MEMS1).

3. Hyper-frequency power limiter according to claim 1 or claim 2, wherein the commutators of the limiter are all identical.

4. Hyper-frequency power limiter according to any one of the preceding claims, each commutator of the limiter comprising a movable electrode ($4_1$, $4_2$) above the signal line (LS), **characterised in that** each commutator of the limiter comprises a resistor (R) having an identical value in series with the movable electrode thereof and the earth.

5. Hyper-frequency power limiter according to any one of the preceding claims, **characterised in that** it further comprises a source (U) of direct voltage ($V_{DC}$) on the signal line (LS) of the limiter.

6. Hyper-frequency power limiter according to the preceding claim, wherein the voltage source is connected to the signal line at the input and at the output of the limiter, via a decoupling circuit ($DEC_{IN}$, $DEC_{OUT}$) of the direct voltage, of the hyper-frequency signal.

7. Electronic processing device for a hyper-frequency signal, comprising a power limiter according to any one of claims 1 to 6, placed upstream of signal processing circuits.

**Fig. 1a**

**Fig. 1b**

$P_{IN}$

$P_{OUT} \approx P_{IN}$

$Z_0$

$P_{IN}$

$C_{up}$

$Z_0$

**Fig. 2a**

$P_{IN}$

$P_{OUT} < P_{IN}$

$Z_0$

Puissance
réfléchie

$P_{IN}$

$C_{down}$

$Z_0$

**Fig. 2b**

EP 2 648 335 B1

**Fig. 3**

**Fig. 4**

Fig. 5

Fig. 6

Fig. 7

Fig. 8

**Fig. 9**

| $P_{down} = P_{up}$ (dBm) | $P_{down} = P_{up}$ (W) | $V_p(V)$ |
|---|---|---|
| 0 | $10^{-3}$ | 0.158 |
| 10 | $10^{-2}$ | 0.5 |
| 20 | $10^{-1}$ | 1.58 |
| 30 | 1 | 5 |
| 40 | 10 | 15.8 |

**Fig. 10a**

**Fig. 10b**

**Fig. 11a**

**Fig. 11b**

**Fig. 11c**

EP 2 648 335 B1

Fig. 12a

Fig. 12b

**Fig. 13b**

**Fig. 13a**

**Fig. 14a**

**Fig. 14b**

**Fig. 14c**

Fig. 15

Fig. 16

Fig. 17a

Fig. 17b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2930373

- EP 2110881 A

**Littérature non-brevet citée dans la description**

- **X. ROTTENBERG et al.** MEMS Capacitive Series Switches : Optimal Test Vehicles for the RF Self-Biasing Phenomenon. *18th IEEE International Conférence on Micro Electro Mechanical Systems 2005,* 2005, 147-150